# FASCICULE DE BREVET EUROPEEN

(11) **EP 3 373 716 B1**
(45) Date de publication et mention de la délivrance du brevet: **05.05.2021**
(21) Numéro de dépôt: 18158714.8
(22) Date de dépôt: 26.02.2018
(51) Int. Cl.: H05K 7/20

(54) **DISPOSITIF ELECTRONIQUE POUR VEHICULE AUTOMOBILE**
ELEKTRONISCHE VORRICHTUNG FÜR KRAFTFAHRZEUG
ELECTRONIC DEVICE FOR A MOTOR VEHICLE

(30) Priorité: 09.03.2017 FR 1751937
(43) Date de publication de la demande: 12.09.2018
(73) Titulaire: Aptiv Technologies Limited, St. Michael (BB)
(72) Inventeur: Rieke, Matthias, 41063 Moenchengladbach (DE); Feismann, Timo, 48488 Emsbüren (DE)
(74) Mandataire: Vigand, Philippe

(56) Documents cités:
- WO-A1-2012/066226
- US-A- 5 486 980
- US-A- 5 734 553

## Description

### DOMAINE TECHNIQUE

La présente invention concerne un dispositif électronique pour véhicule automobile et plus particulièrement un dispositif de dissipation thermique pour carte à circuit imprimé.

### ARRIERE-PLAN TECHNOLOGIQUE DE L'INVENTION

Les unités de contrôle électronique embarquées dans les véhicules automobiles comprennent de plus en plus de composants semi-conducteurs tels que des microcontrôleurs, des composants de traitements de signaux ou encore des interrupteurs de puissance. La quantité de chaleur générée par les dispositifs à semi-conducteur est en constante augmentation. Il est généralement connu de fournir des dissipateurs de chaleur comportant des piliers de refroidissement qui sont utilisés pour transférer la chaleur d'un composant électronique à l'air environnant. Selon la littérature technique, les piliers de refroidissement des dissipateurs de chaleurs sont également dénommés 'aiguilles' ou encore 'ailettes à broches'. Plus communément, le terme anglo-saxon utilisé pour désigner un dissipateur de chaleur à piliers de refroidissement est 'pin fin heat sink'. Les dissipateurs de chaleur à piliers de refroidissement sont également applicables à des dispositifs multi composants telles que des alimentations de puissance ou encore des unités de contrôle électronique.

Afin d'accroitre la capacité de dissipation thermique des dissipateurs de chaleur, il est connu d'utiliser le mécanisme de transfert de chaleur par convection, soit par convection naturelle, soit par convection forcée à l'aide d'un ventilateur.

Cependant, ce type de solution n'est pas entièrement satisfaisant pour plusieurs raisons. De façon générale un dissipateur de chaleur n'est pas modulable, c'est-à-dire que son dimensionnement limite la dissipation thermique à une valeur maximale fixe puisque sa surface de dissipation est figée. De plus la convection naturelle ne permet généralement pas de refroidir de manière uniforme l'ensemble des piliers de refroidissement du dissipateur de chaleur. La convection forcée nécessite généralement une implémentation complexe d'un ventilateur encombrant par-dessus l'ensemble des piliers de refroidissement du dissipateur de chaleur. Le document US 5 486 980 A concerne la dissipation de l'énergie thermique générée par des dispositifs électroniques.

Par conséquent, un objet de la présente invention est de fournir un dissipateur de chaleur à piliers de refroidissement ayant une capacité de dissipation thermique améliorée qui surmonte les problèmes mentionnés ci-dessus. D'autres buts et avantages de la présente invention apparaîtront au vu de la description qui suit.

### RESUME DE L'INVENTION

Un assemblage électronique comportant un dispositif de refroidissement comprend un plateau de refroidissement équipé sur sa face supérieure d'une pluralité de piliers refroidissement; une première carte à circuit imprimé comportant au moins une zone génératrice de chaleur en appui contre la face inférieure du plateau de refroidissement; chaque pilier comportant un moyen de ventilation comprenant un moyeu équipé de pales, les pales étant agencées axialement le long de chaque pilier de sorte à pouvoir tourner autour du pilier créant ainsi un flux d'air de refroidissement des piliers.

Chaque moyeu peut être monté à rotation sur un pilier de refroidissement. Chaque pilier de refroidissement peut avoir une forme globalement cylindrique à base circulaire. Chaque pilier de refroidissement peut comprendre à son extrémité libre un épaulement sur lequel le moyeu est monté en butée. Les pales peuvent être formées par des tiges rectilignes s'étendant depuis le moyeu jusqu'à leur extrémité libre. Chaque tige rectiligne peut comporter une aube de ventilation s'étendant axialement le long de chaque tige.

L'assemblage électronique peut également comprendre un dispositif d'entrainement en rotation commandé par un circuit électronique de commande agencé sur une seconde carte à circuit imprimé. La seconde carte à circuit imprimé peut être agencée à plat par-dessus les extrémités libres des piliers de refroidissement. Le circuit électronique de commande peut être agencé sur la face de la seconde carte à circuit imprimé en vis-à-vis des moyeux. Chaque moyeu peut être monté en rotation sur la seconde carte à circuit imprimé. Le dispositif d'entrainement en rotation peut être de type électromagnétique. Le dispositif d'entrainement en rotation de type électromagnétique peut comprendre pour chaque moyen de ventilation: 3 bobines agencées sur la seconde carte à circuit imprimé formant un stator magnétique et 2 aimants permanents agencés sur le moyeu formant un rotor magnétique.

### BREVE DESCRIPTION DES DESSINS

D'autres caractéristiques, buts et avantages de l'invention apparaîtront à la lecture de la description détaillée qui va suivre, et en regard des dessins annexés, donnés à titre d'exemple non limitatif et sur lesquels:
- La figure 1 est une vue schématique en perspective d'un dispositif de refroidissement comprenant une pluralité de piliers refroidissement selon l'invention.
- La figure 2 est une vue schématique en perspective d'un premier mode de réalisation d'un moyen de ventilation des piliers de refroidissement de la figure 1.
- La figure 3 est une vue schématique en perspective d'un second mode de réalisation d'un moyen de ventilation des piliers de refroidissement de la figure 1.
- La figure 4 est une vue schématique d'un premier mode de réalisation d'un assemblage électronique selon l'invention comportant le dispositif de refroidissement de la figure 1 équipé du moyen de ventilation de la figure 2.
- La figure 5 est une vue schématique en perspective d'une carte à circuit imprimé sur laquelle un circuit électronique de commande en rotation des moyens de ventilations des piliers de refroidissement est monté.
- La figure 6 est un vue schématique détaillée du bobinage du circuit de commande de la figure 5.
- La figure 7 est une vue schématique en perspective du moyen de ventilation de la figure 2 équipés de deux aimants permanents.
- La figure 8 est une vue schématique en coupe du moyen de ventilation de la figure 7 monté en rotation sur la carte à circuit imprimé de la figure 5.
- La figure 9 est une vue schématique d'un second mode de réalisation d'un assemblage électronique selon l'invention comportant le dispositif de refroidissement de la figure 1 équipé du moyen de ventilation commandé en rotation par le circuit électronique de commande agencé sur la carte à circuit imprimé de la figure 5.

### DESCRIPTION DES MODES DE REALISATION PREFERES

Afin de faciliter la description, et de façon non limitative, un repère orthogonal comprenant un axe longitudinal L, un axe transversal T et un axe vertical V est défini. Des orientations « bas », « haut », « dessus », « dessous », « inférieure » et « supérieure » sont définies selon la direction verticale.

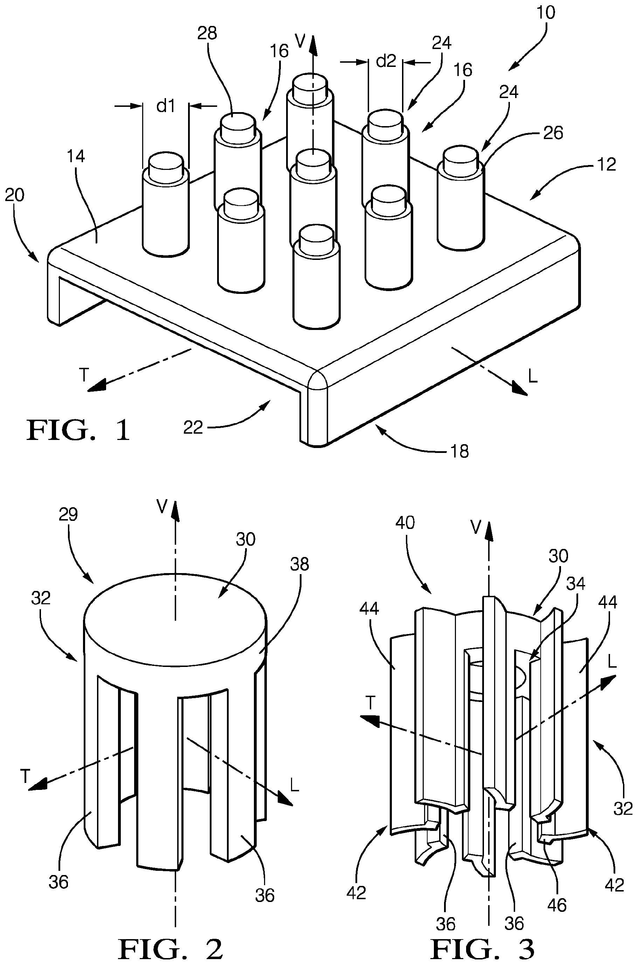

Selon la figure 1, un dispositif de refroidissement 10 prévu pour dissiper la chaleur de composant électronique générant de la chaleur comprend un plateau de refroidissement 12 agencé selon un plan horizontal défini par l'axe longitudinal et l'axe transversal. Le plateau de refroidissement 12 est équipé sur sa face supérieure 14 d'une pluralité de piliers refroidissement 16.

Le plateau de refroidissement 12 est globalement rectangulaire. Deux parois latérales 18, 20 sont agencées à deux extrémités opposées du plateau de refroidissement 12 de sorte à pouvoir maintenir le plateau de refroidissement 12 surélevé lorsqu'il est disposé, par exemple, sur un fond de boîtier, et donc de sorte à ne pas écraser les composants électroniques venant en appui contre la face inférieure 22 du plateau de refroidissement 12.

Les piliers de refroidissement 16 sont agencés perpendiculairement au plateau de refroidissement 12 et font saillies, selon la direction de l'axe vertical, à partir de celui-ci. Selon le mode de réalisation représenté, les piliers de refroidissement 16 sont disposés en rangées alignées sur le plateau de refroidissement 12. Les piliers de refroidissement 16 pourraient également être disposés en rangées décalées. Les piliers de refroidissement 16 représentés sont globalement de forme cylindrique à base circulaire. Chaque pilier de refroidissement 16 comprend à son extrémité libre 24, un épaulement 26 prévu pour recevoir un moyeu d'un moyen de ventilation du pilier 16 monté en butée contre l'épaulement 26. L'épaulement 26 est réalisé par une restriction du diamètre de la base circulaire du cylindre formant le pilier sur une faible portion de l'extrémité libre 24 du pilier de refroidissement 16. Le diamètre de la base circulaire du cylindre est dénommé diamètre principal d1, par opposition au diamètre de la portion de l'extrémité libre 24, dénommé diamètre secondaire d2.

Alternativement, les piliers pourraient être de forme cylindrique à base rectangulaire. Alternativement, les piliers peuvent être de forme cylindrique uniforme, c'est-à-dire sans que leur extrémités libres 24 comprennent une restriction formant un épaulement 26. Dans ce cas, un moyeu d'un moyen de ventilation pourra être monté en butée directement sur la face supérieure 28 de l'extrémité libre 24 du pilier 16 ou encore pourra être monté à rotation autour du pilier 16 à la base du pilier, c'est-à-dire en butée sur la face supérieure 14 du plateau de refroidissement 12.

Selon la figure 2, un premier mode de réalisation d'un moyen de ventilation 29 de pilier de refroidissement 16 est représenté. Le moyen de ventilation 29 comprend un moyeu 30 équipé de pales 32. Le moyeu 30 est de forme globalement cylindrique à base circulaire agencée selon le plan horizontal. Afin de pouvoir s'insérer sur un pilier de refroidissement 16 tel que décrit selon la figure 1, c'est-à-dire afin de venir en butée sur l'épaulement 26 d'un pilier de refroidissement 16, le moyeu 30 comprend en son centre, sur sa face inférieure (visible sur la figure 3), un trou borgne 34 de dimension complémentaire avec le diamètre secondaire d2 de l'extrémité libre 24 du pilier de refroidissement 16.

Les pales 32 du moyen de ventilation 29 sont formées par des tiges rectilignes 36 s'étendant verticalement vers le bas depuis le pourtour 38 du moyeu 30. Les tiges rectilignes 36 sont régulièrement réparties sur le pourtour 38 du moyeu 30. Idéalement les tiges 36 sont au nombre de 6 ou 8, selon le diamètre principal d1 du pilier de refroidissement 16.

Le moyeu 30 a un diamètre d'une dimension sensiblement supérieure au diamètre principal d1 des piliers de refroidissement 16, c'est-à-dire, ayant un diamètre permettant aux tiges rectilignes 36 de pouvoir tourner en rotation autour du pilier de refroidissement 16 tout en étant agencées au plus proche de celui-ci afin de créer un flux d'air de refroidissement des piliers 16.

Selon la figure 3, un second mode de réalisation d'un moyen de ventilation 40 est représenté. Le moyen de ventilation 40 représenté comprend en plus de la structure du moyen de ventilation 29 décrit au travers de la figure 2, des aubes 42 fixées sur les tiges rectilignes 36. Les aubes 42 sont en forme de palettes rectangulaires 44 dont un côté s'étend verticalement depuis l'extrémité libre 46 des tiges rectilignes 36 jusqu'à la surface supérieure du moyeu 30. La structure de ce mode de réalisation du moyen de ventilation 40 est comparable à celui d'une roue à aube d'un dispositif hydraulique.

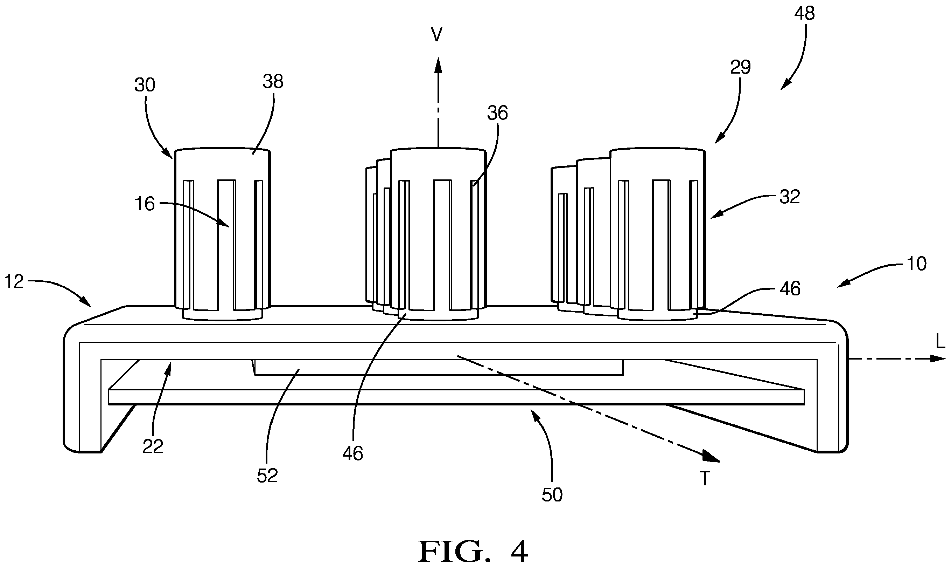

Selon la figure 4, un premier mode de réalisation d'un assemblage électronique 48 comprenant le dispositif de refroidissement 10 de la figure 1 équipé du moyen de ventilation 29 de la figure 2 est représenté. L'assemblage électronique 48 comprend également une première carte à circuit imprimé 50 comprenant un composant électronique 52 pouvant générer de la chaleur. A des fins de refroidissement, le composant électronique 52 est en appui sur la face inférieure 22 du plateau de refroidissement 12. De façon plus générale, l'invention de se limite pas uniquement au refroidissement d'un composant électronique 52 pouvant générer de la chaleur, mais s'étend à toutes les zones d'une carte à circuit imprimé pouvant générer de la chaleur, les dites zones pouvant générer de la chaleur pouvant également être en appui contre la face inférieure 22 du plateau de refroidissement 12 par l'intermédiaire d'une pâte thermique.

Selon ce premier mode de réalisation de l'assemblage électronique 48, chaque piler de refroidissement 16 du dispositif de refroidissement 10 de la figure 1 est équipé du moyen de ventilation 29 décrit à la figure 2. Le moyeu 30 de chaque moyen de ventilation 29 est monté à rotation sur chaque pilier de refroidissement 16 de sorte à pouvoir entrainer les pales 32 autour du pilier de refroidissement 16 sur lequel il est monté. Plus précisément, la portion cylindrique de diamètre secondaire d2 de l'extrémité libre 24 de chaque pilier de refroidissement 16 est insérée dans le trou borgne 34 central de chaque moyeu 30. Le moyeu 30 est donc monté en butée sur l'épaulement 26 formé par la restriction du diamètre du pilier refroidissement 16. Les tiges rectilignes 36 de chaque moyen de ventilation 29 s'étendent verticalement vers le bas, le long de chaque pilier de refroidissement 16 depuis le pourtour 38 du moyeu 30 jusqu'à leur propre extrémités libres 46. Les extrémités libres 46 des tiges rectilignes 36 sont quasiment au contact du plateau de refroidissement 12 de sorte qu'elles s'étendent quasiment le long de toute la longueur, selon la direction vertical, du pilier de refroidissement 16 sur lequel le moyen de ventilation 29 est monté.

Ce mode de réalisation présente plusieurs avantages en comparaison avec l'état de la technique connue.

Lorsque le dispositif est soumis à un flux d'air selon une direction permettant la rotation des pales 32 des moyens de ventilation 29, les moyens de ventilations 29 viennent générer un flux d'air tout autour du pilier de refroidissement 16, augmentant ainsi leur capacité de dissipation thermique, alors que sans les moyens de ventilation 29, le flux d'air vient refroidir uniquement la partie du pilier 16 avec laquelle il vient au contact.

Il convient que dans le cas d'une rotation des pales 32 des moyens de ventilation par un flux d'air, le second mode de réalisation du moyen de ventilation 40 décrit à la figure 3, c'est-à-dire, le moyen de ventilation 40 équipé d'aubes 42, s'avérera plus efficace mais plus encombrant.

De plus, dans le cas où le moyen de ventilation 29, 40 est fait d'un matériau conducteur de chaleur, telle que l'aluminium, l'ajout des moyens de ventilation 29, 40 sur chaque piliers de refroidissement 16 permet d'augmenter la surface de dissipation de chaleur du dispositif de refroidissement 10 et donc d'accroitre la capacité de dissipation thermique du dispositif de refroidissement 10. Il est à noter également, que dans le cas d'un moyen de ventilation 40 comprenant des aubes 42 en aluminium, la surface utile de dissipation thermique du moyen de ventilation 40 est également augmentée et donc la dissipation thermique de l'assemblage électronique 48 est améliorée.

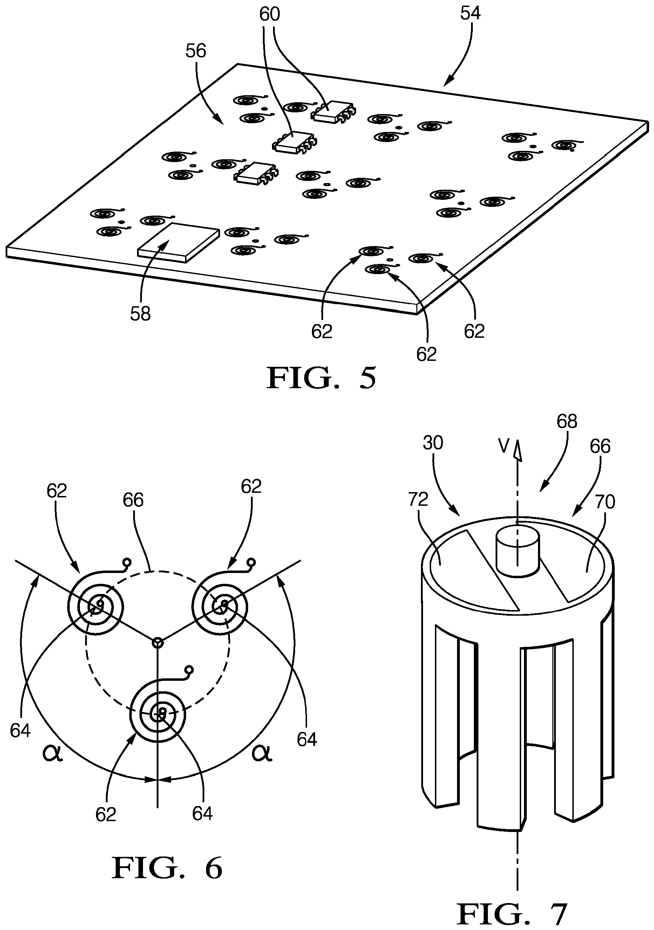

Selon la figure 5, une seconde carte à circuit imprimé 54 comprenant un circuit électronique de commande 56 de rotation des moyens de ventilation 29, 40 est représentée. La seconde carte à circuit imprimé 54 comprend, sur une seule face, un microcontrôleur 58, des interrupteurs électroniques 60 à base de transistors à effets de champs et des bobines magnétiques 62. Le circuit de commande 56 est un circuit de commande magnétique, tel un stator magnétique. Le microcontrôleur 58 commande les interrupteurs 60 autorisant ou non le passage d'un courant dans les bobines magnétiques 62. Les bobines magnétiques 62 sont regroupées par groupe de trois bobines 62. Selon le mode de réalisation, les bobines magnétiques 62 sont des motifs en forme de spirale ronde imprimés sur la seconde carte à circuit imprimé 54. Chaque groupe de 3 bobines 62 est prévue pour commander un rotor magnétique.

Selon la figure 5 et la figure 6, les centres des trois spirales 64 sont régulièrement agencés en cercle, et donc espacés entre eux d'un angle α d'environ 120 degrés. Plus précisément, les centres 64 des trois spirales sont agencés sur un cercle virtuel 66, représenté en pointillé sur la figure 6, de rayon sensiblement inférieur au rayon de la base cylindrique d'un moyeu du moyen de ventilation décrit à la figure 2 de sorte que les trois bobines 62 puissent être électro-magnétiquement couplées à un rotor magnétique monté sur le moyeu 30 du moyen de ventilation 29, 40.

L'homme du métier conviendra que d'autre type de bobines 62 peuvent tout à fait convenir afin de commander un rotor magnétique. L'homme de métier conviendra également que le circuit de commande 56 pourrait être réalisé sur plusieurs faces d'un circuit imprimé multicouche.

Le moyen de ventilation 66 de la figure 7 diffère uniquement de celui représenté à la figure 2 en ce que des éléments magnétiques 68 sont montés sur le moyeu 30. Plus précisément, deux aimants permanents 70, 72 de polarité opposés (Nord-Sud) sont agencés sur le moyeu 30, tel un rotor magnétique, de sorte à coopérer avec les bobines 62 du circuit électronique de commande 56.

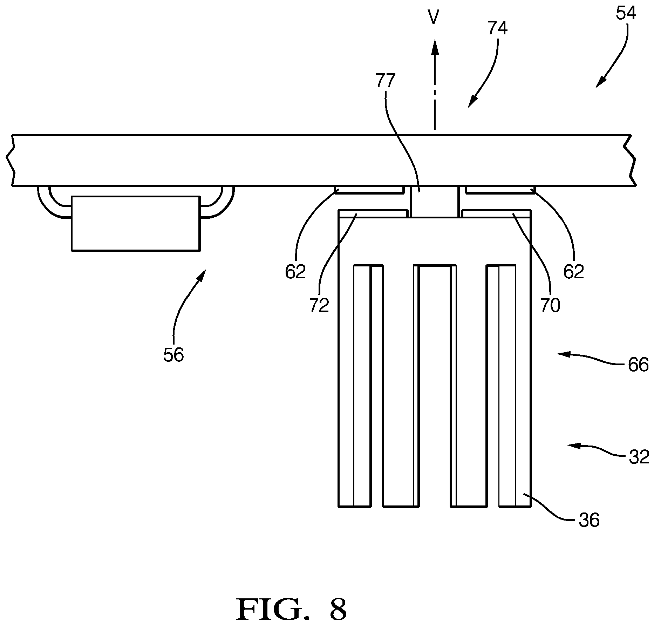

Selon la figure 8, la seconde carte à circuit imprimé 54 équipé du circuit électronique de commande 56 décrit à la figure 5 est fixée sur le moyen de ventilation 66 décrit à la figure 7. Un dispositif d'entrainement en rotation 74 du moyen de ventilation 66 est formé. Il comprend le circuit électronique de commande 56 de la seconde carte à circuit imprimé 54 dont les bobines 62 sont couplées électro magnétiquement aux deux aimants permanents 70, 72 du moyen de ventilation 66. Afin d'optimiser les performances du dispositif d'entrainement en rotation 74, le moyen de ventilation 66 équipé des deux aimants permanents 70, 72 est monté en rotation sur la seconde carte à circuit imprimé 54 de sorte que les deux aimants permanents 70, 72 sont agencés en vis-à-vis et au plus près du groupe de trois bobines 62 du circuit électronique de commande 56. Un moyen de fixation en rotation 77 du moyen de ventilation 66 raccorde la seconde carte à circuit imprimé 54 au moyen de ventilation 66 entre le centre du cercle virtuel 66 sur lequel sont agencées les trois bobines 66 et l'axe de rotation du moyeu 30 du moyen de ventilation 66.

Alternativement, l'entrainement en rotation des moyen de ventilations 29, 40 pourrait se faire par des dispositifs non magnétiques, comme par exemple des dispositifs mécaniques.

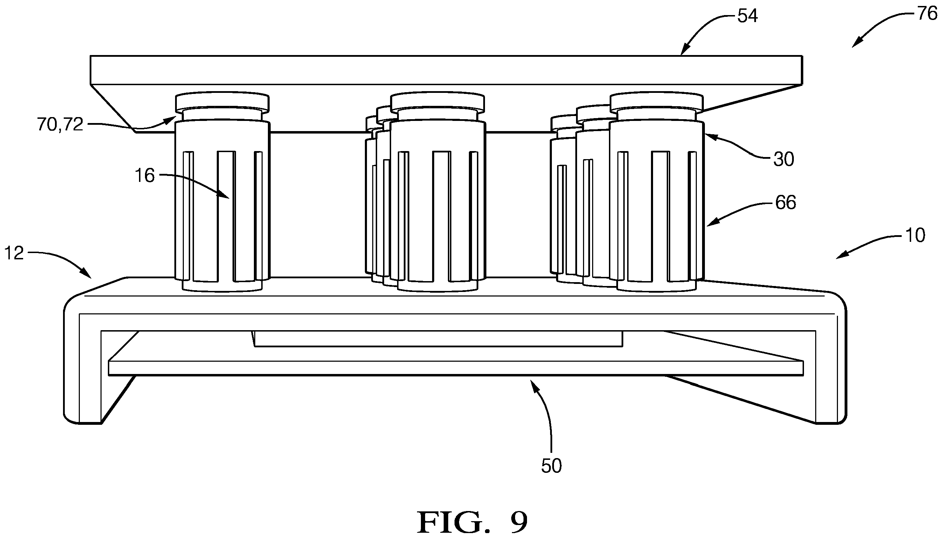

Selon la figure 9, un second mode de réalisation d'un assemblage électronique 76 est représenté. Celui-ci diffère de premier mode de réalisation en ce que chaque moyeu 30 des moyen de ventilation 66 monté à rotation sur un pilier de refroidissement 16 est équipé des deux aimants permanents 70, 72 de polarité opposée tel que décrit à la figure 7. Selon ce second mode de réalisation, le moyeu 30 de chaque moyen de ventilation 66 est également monté en rotation sur la seconde carte à circuit imprimé 54. La seconde carte à circuit imprimé 54 est donc disposée à plat par-dessus les piliers de refroidissement 16, mais elle n'est pas en contact direct avec les piliers de refroidissement 16. En effet, selon le mode de réalisation décrit à la figure 2 et à la figure 3, le moyeu 30 comprend en son centre, sur sa face inférieure, un trou borgne 34 et non pas un trou traversant.

Cependant une alternative à ce mode de réalisation pourrait consister à ce que le moyeu 30 soit équipé en son centre d'un trou traversant et que l'extrémité libre 24 du pilier de refroidissement 16 soit de dimension suffisamment grande selon la direction verticale pour qu'elle puisse s'étendre selon la direction verticale au-delà du moyeu 30. Ainsi, les piliers de refroidissement 16 pourraient servir de plots de maintien à la seconde carte à circuit imprimé 54.

Alternativement, le moyen de ventilation 40 décrit à la figure 3, c'est-à-dire comportant des aubes 42 peut également être équipé d'aimants permanents 70, 72 sur son moyeu 30 et donc peut également être monté sur les piliers de refroidissement 16 du mode de réalisation de la figure 9. En plus d'augmenter le flux d'air autour des piliers de refroidissement 16, les aubes 42 peuvent permettre à un moyen de ventilation 66 dont le dispositif d'entrainement 74 serait défectueux, de continuer à tourner autour du pilier 16 sur lequel il est monté en profitant des flux d'air voisin générer par les moyens de ventilation 66 à proximité.

## Revendications

1. Assemblage électronique (48, 76) comportant
un dispositif de refroidissement (10) comprenant un plateau de refroidissement (12) équipé sur sa face supérieure (14) d'une pluralité de piliers refroidissement (16);
une première carte à circuit imprimé (50) comportant au moins une zone génératrice de chaleur (52) en appui contre la face inférieure (22) du plateau de refroidissement (12);
**caractérisé en ce que** chaque pilier (16) comporte un moyen de ventilation (29) comprenant un moyeu (30) équipé de pales (32), les pales (32) étant agencées axialement le long de chaque pilier (16) de sorte à pouvoir tourner autour du pilier (16) créant ainsi un flux d'air de refroidissement des piliers (16).

2. Assemblage électronique (48, 76) selon la revendication précédente **caractérisé en ce que** chaque moyeu (30) est monté à rotation sur un pilier de refroidissement (16).

3. Assemblage électronique (48, 76) selon la revendication 2 **caractérisé en ce que** chaque pilier de refroidissement (16) a une forme globalement cylindrique à base circulaire.

4. Assemblage électronique (48, 76) selon l'une quelconque des revendications précédentes **caractérisé en ce que** chaque pilier de refroidissement (16) comprend à son extrémité libre (24) un épaulement (26) sur lequel le moyeu (30) est monté en butée.

5. Assemblage électronique (48, 76) selon l'une quelconque des revendications précédentes **caractérisé en ce que** les pales (32) sont formées par des tiges rectilignes (36) s'étendant depuis le moyeu (30) jusqu'à leur extrémité libre (46).

6. Assemblage électronique (48, 76) selon la revendication 5 **caractérisé en ce que** chaque tige rectiligne (36) comporte une aube de ventilation (42) s'étendant axialement le long de chaque tige (36).

7. Assemblage électronique (48, 76) selon l'une quelconque des revendications précédentes **caractérisé en ce qu'**il comprend un dispositif d'entrainement en rotation (74) commandé par un circuit électronique de commande (56) agencé sur une seconde carte à circuit imprimé (54).

8. Assemblage électronique (48, 76) selon la revendication 7 **caractérisé en ce que** la seconde carte à circuit imprimé (54) est agencée à plat par-dessus les extrémités libres (24) des piliers de refroidissement (16).

9. Assemblage électronique (48, 76) selon la revendication 8 **caractérisé en ce que** le circuit électronique de commande (56) est agencé sur la face de la seconde carte à circuit imprimé (54) en vis-à-vis des moyeux (30).

10. Assemblage électronique (48, 76) selon la revendication 8 ou 9 **caractérisé en ce que** chaque moyeu (30) est monté en rotation sur la seconde carte à circuit imprimé (54).

11. Assemblage électronique (48, 76) selon l'une quelconque des revendications 7 à 10 **caractérisé en ce que** le dispositif d'entrainement en rotation (74) est de type électromagnétique.

12. Assemblage électronique (48, 76) selon la revendication 11 **caractérisé en ce que** le dispositif d'entrainement en rotation (74) de type électromagnétique comprend pour chaque moyen de ventilation (66) :
3 bobines (62) agencées sur la seconde carte à circuit imprimé (54) formant un stator magnétique;
2 aimants permanents (70, 72) agencés sur le moyeu (30) formant un rotor magnétique.

## Patentansprüche

1. Elektronische Anordnung (48, 76), aufweisend eine Kühlvorrichtung (10), umfassend eine Kühlplatte (12), die auf ihrer oberen Fläche (14) mit einer Vielzahl von Kühlpfeilern (16) ausgestattet ist;
eine erste Karte mit gedrucktem Schaltkreis (50), aufweisend mindestens eine wärmeerzeugende Zone (52) in Abstützung auf der unteren Fläche (22) der Kühlplatte (12);
**dadurch gekennzeichnet, dass** jeder Pfeiler (16) ein Lüftungsmittel (29) aufweist, das eine Nabe (30) umfasst, die mit Blättern (32) ausgestattet ist, wobei die Blätter (32) entlang jedes Pfeilers (16) axial angeordnet sind, so dass sie um den Pfeiler (16) drehen können und so einen Luftstrom zum Kühlen der Pfeiler (16) erzeugen.

2. Elektronische Anordnung (48, 76) nach vorangehendem Anspruch, **dadurch gekennzeichnet, dass** jede Nabe (30) auf einem Kühlpfeiler (16) rotatorisch angebracht ist.

3. Elektronische Anordnung (48, 76) nach Anspruch 2, **dadurch gekennzeichnet, dass** jeder Kühlpfeiler (16) eine allgemein zylindrische Form mit runder Basis hat.

4. Elektronische Anordnung (48, 76) nach einem der vorangehenden Ansprüche, **dadurch gekennzeichnet, dass** jeder Kühlpfeiler (16) an seinem freien Ende (24) einen Absatz (26) umfasst, auf dem die Nabe (30) in Anschlag angebracht ist.

5. Elektronische Anordnung (48, 76) nach einem der vorangehenden Ansprüche, **dadurch gekennzeichnet, dass** die Blätter (32) von geraden Stangen (36) gebildet sind, die sich ab der Nabe (30) bis zu ihrem freien Ende (46) erstrecken.

6. Elektronische Anordnung (48, 76) nach Anspruch 5, **dadurch gekennzeichnet, dass** jede gerade Stange (36) eine Lüftungsschaufel (42) aufweist, die sich entlang jeder Stange (36) axial erstreckt.

7. Elektronische Anordnung (48, 76) nach einem der vorangehenden Ansprüche, **dadurch gekennzeichnet, dass** sie eine Rotationsantriebsvorrichtung (74) umfasst, die von einem elektronischen Steuerkreis (56) gesteuert wird, der auf einer zweiten Karte mit gedrucktem Schaltkreis (54) angeordnet ist.

8. Elektronische Anordnung (48, 76) nach Anspruch 7, **dadurch gekennzeichnet, dass** die zweite Karte mit gedrucktem Schaltkreis (54) flach oberhalb der freien Enden (24) der Kühlpfeiler (16) angeordnet ist.

9. Elektronische Anordnung (48, 76) nach Anspruch 8, **dadurch gekennzeichnet, dass** der elektronische Steuerkreis (56) auf der Fläche der zweiten Karte mit gedrucktem Schaltkreis (54) gegenüber den Naben (30) angeordnet ist.

10. Elektronische Anordnung (48, 76) nach Anspruch 8 oder 9, **dadurch gekennzeichnet, dass** jede Nabe (30) auf der zweiten Karte mit gedrucktem Schaltkreis (54) rotatorisch angebracht ist.

11. Elektronische Anordnung (48, 76) nach einem der Ansprüche 7 bis 10, **dadurch gekennzeichnet, dass** die Rotationsantriebsvorrichtung (74) vom elektromagnetischen Typ ist.

12. Elektronische Anordnung (48, 76) nach Anspruch 11, **dadurch gekennzeichnet, dass** die Rotationsantriebsvorrichtung (74) vom elektromagnetischen Typ für jedes Lüftungsmittel (66) umfasst:
3 Spulen (62), die auf der zweiten Karte mit gedrucktem Schaltkreis (54) angeordnet sind, die einen magnetischen Stator bilden;
2 Permanentmagnete (70, 72), die auf der Nabe (30) angeordnet sind, die einen magnetischen Rotor bilden.

## Claims

1. An electronic assembly (48, 76) including:
a cooling device (10) comprising a cooling tray (12) equipped on its upper face (14) with a plurality of cooling pillars (16);
a first printed circuit board (50) including at least one heat-generating area (52) bearing against the lower face (22) of the cooling tray (12);
**characterized in that** each pillar (16) includes a ventilation means (29) comprising a hub (30) equipped with vanes (32), the vanes (32) being arranged axially along each pillar (16) so as to be able to rotate around the pillar (16) thus creating a flow of air for cooling the pillars (16).

2. The electronic assembly (48, 76) according to the preceding claim **characterized in that** each hub (30) is rotatably mounted on a cooling pillar (16).

3. The electronic assembly (48, 76) according to claim 2 **characterized in that** each cooling pillar (16) has a generally cylindrical shape with a circular base.

4. The electronic assembly (48, 76) according to any one of the preceding claims **characterized in that** each cooling pillar (16) comprises at its free end (24) a shoulder (26) on which the hub (30) is mounted in abutment.

5. The electronic assembly (48, 76) according to any one of the preceding claims **characterized in that** the vanes (32) are formed by rectilinear rods (36) extending from the hub (30) up to their free end (46).

6. The electronic assembly (48, 76) according to claim 5 **characterized in that** each rectilinear rod (36) includes a ventilation blade (42) extending axially along each rod (36).

7. The electronic assembly (48, 76) according to any one of the preceding claims **characterized in that** it comprises a rotational drive device (74) controlled by an electronic control circuit (56) arranged on a second printed circuit board (54).

8. The electronic assembly (48, 76) according to claim 7 **characterized in that** the second printed circuit board (54) is arranged flat above the free ends (24) of the cooling pillars (16) .

9. The electronic assembly (48, 76) according to claim 8 **characterized in that** the electronic control circuit (56) is arranged on the face of the second printed circuit board (54) with respect to the hubs (30).

10. The electronic assembly (48, 76) according to claim 8 or 9 **characterized in that** each hub (30) is rotatably mounted on the second printed circuit board (54).

11. The electronic assembly (48, 76) according to any one of claims 7 to 10 **characterized in that** the rotational drive device (74) is of the electromagnetic type.

12. The electronic assembly (48, 76) according to claim 11 **characterized in that** the rotational drive device (74) of the electromagnetic type comprises, for each ventilation means (66) :
3 coils (62) arranged on the second printed circuit board (54) forming a magnetic stator;
2 permanent magnets (70, 72) arranged on the hub (30) forming a magnetic rotor.
